# EUROPEAN PATENT APPLICATION

(11) **EP 4 650 789 A1**
(43) Date of publication of application: **19.11.2025**
(21) Application number: 24425018.9
(22) Date of filing: 16.05.2024
(51) Int. Cl.: G01R 3/00

(54) **METHOD FOR MANUFACTURING AN INTERFACE ELEMENT WITH ELASTIC PROPERTIES PROVIDED WITH INTERNAL ELECTRIC VIAS, IN PARTICULAR FOR CONNECTING A DEVICE TO BE TESTED TO A TESTING HEAD, AND INTERFACE ELEMENT OBTAINED WITH SAID METHOD**

(71) Applicant: Microtest S.p.A., 56010 Vicopisano (PI) (IT)
(72) Inventor: AMELIO, Guiseppe, 55100 San Pietro (LU) (IT)
(74) Representative: Botti & Ferrari S.p.A.

(57) **Abstract**

The present disclosure relates to a method for manufacturing an interface element (1) arranged to put a plurality of terminations of a device to be tested in contact with the corresponding channels of a testing head, comprising the steps of:
arranging a planar lower support (3);
depositing a first photoresist layer (2i) on said lower support (3);
etching said first photoresist layer (2i) so as to form a plurality of through openings in said first photoresist layer (2i);
filling said plurality of through openings with a conductive material so as to form at least one conductive segment (24₁);
repeating the above steps up to reach a desired thickness, where the conductive segments which are contiguous to each other define a plurality of conductors;
removing the photoresist layers;
embedding said plurality of conductors in an elastomeric matrix.

## Description

### Field of application

The present invention relates to a method for manufacturing an interface element provided with one or more internal electric vias traversing from side to side a covering body having elastomeric properties.

This interface element finds a useful application in a testing head arranged to perform tests on electronic devices, for example integrated electronic circuits.

In particular, the interface element allows to put a plurality of terminations or pads of the device in contact with corresponding channels of the testing head so as to automatically perform some desired tests on the electric device to be tested. By doing so it is possible to identify and discard defective products.

It should also be noted that the interface element can find a useful application in any electronic equipment where a plurality of electronic terminations must be put in temporary electric contact, in particular in any testing equipment on electronic devices or components thereof.

### Prior art

In the field of the invention, it is known to use testing heads of the above type which usually comprise a pair of guide plates arranged parallel to each other in a prefixed spaced apart relationship and provided with a plurality of guide and housing holes for probes or needles which represent contact elements for the terminations of the integrated circuits.

These contact probes of the testing head are formed by wires of special alloys which have peculiar both electrical and mechanical properties, and which pass through the holes of the plates emerging from one of the two plates with an end or contact head.

The probes are mounted and held between the two plates in a position which is substantially perpendicular to the plates themselves so that, in the jargon of this specific technical field, they are referred to as "vertical probes". This specific substantially vertical configuration allows a relatively high number of probes per unit area to be incorporated, so as to be able to perform tests even on the integrated circuits characterized by extremely reduced pitches, in the order of 30-40 pm for the latest generation integrated circuits.

More particularly, the holes of the respective plates through which a given probe passes are in general slightly offset so that each probe is axially movable through the respective housing holes but with some friction which, along with the inherent flexibility of the probes themselves, confers a certain overall ability to withstand a compression to the testing head assembly, as if it were slightly cushioned.

Although substantially meeting the field requirements, the above-outlined device has nevertheless some drawbacks, related to the production cost, to the relative fragility of the probes which can get damaged requiring a complex replacement work, and finally to the difficulties in forming extremely reduced pitches which are inherent in prior art technology.

The technical problem underlying the present invention is to manufacture a new interface element which solves, or at least mitigates, the above-lamented drawbacks, and which allows in particular an effective cushioning without resorting to mechanical elements - such as needle probes - which are difficult to assemble and replace.

### Summary of the invention

The solution idea underlying the present invention is to develop a new method for manufacturing a bearing of elastomeric material in which some metal conductors performing the probe function are embedded, wherein the bearing elasticity required to cushion the contacts is preferably ensured by a non-vertical conformation of the above conductors.

Said bearing can thus replace the current vertical probes. It should be noted that the term "vertical" refers to a prevalent use of the probe, but it should not be understood in a limited sense. In the context of the present application, a direction which is substantially orthogonal to the prevalent planar development of the interface element is to be understood as vertical.

A person skilled in the art will appreciate how the above method for manufacturing an interface element allows an advantageous manufacture of the interface allowing only ultimately the deposition of an elastomeric matrix, thus the hardening thereof.

In fact, in the present method, the elastomeric matrix must not perform the function of preliminary support during the formation of the electric vias, this function being performed by a plurality of photoresist layers which can be easily added and dissolved.

Advantageously, as it will be seen, the presence of a plurality of photoresist layers allows, when applying this method, the possibility of alternating among the various arranged photoresist layers, negative photoresist layers and positive photoresist layers arranged in any combination.

Advantageously, one of the faces of the device, for example the lower face, can be integrally associated with an electronic substrate with which the electrical connection must be performed. This substrate can be a printed board, a wafer, or other device or device part.

In a first embodiment of the present invention, each of said conductors comprises a plurality of conductive segments oriented in a different direction and overlapped in the vertical direction.

Thanks to this expedient, it is possible to form a spring structure wherein the segment alternation confers elasticity to the entire conductor and, accordingly, to the interface element.

Preferably, the conductive segments are, in this case, vertical conductive segments, oriented along the vertical direction, alternated with horizontal segments, oriented along a direction which is horizontal to the faces of the interface element.

A bending of the successive vertical segments can be thereby obtained, while keeping the substantial linearity of the entire conductor, thus forming the above-discussed spring structure.

Preferably, said horizontal segments are vertically overlapped, while said vertical segments are vertically overlapped two by two.

This conformation keeps the axial dimensions of the conductors limited.

In the here-outlined spring structure, the different conductors have an identical structure with respect to each other, the vertical segments of the different conductors being parallel and equally spaced from each other, the horizontal segments of the conductors lying on a same intermediate plane of the interface element.

The above-identified technical problem is also solved by a method for manufacturing an interface element arranged to put a plurality of terminations of a device to be tested in contact with corresponding channels of a testing head, comprising the steps of:
a) arranging a planar lower support;
b) depositing a first photoresist layer on said lower support;
c) etching said first photoresist layer so as to form a plurality of through openings in said first photoresist layer;
d) filling said plurality of through openings with a conductive material so as to form at least one conductive segment;
e) depositing a successive photoresist layer on the previous photoresist layer
f) etching said successive photoresist layer so as to form a plurality of through openings, where the through openings of the successive photoresist layer are in line with the through openings of the previous photoresist layer;
g) filling said plurality of through openings of said successive photoresist layer with a conductive material so as to form a corresponding plurality of conductive segments;
h) repeating the steps (e, f, g) up to reach a desired thickness, where the conductive segments which are contiguous to each other define a plurality of conductors;
i) removing the photoresist layers;
j) embedding said plurality of conductors in an elastomeric matrix;

The lower support, on which the first photoresist layer is deposited, can be multilayered.

In a preferred embodiment, at least one first photoresist layer is deposited on a substrate comprised in the lower support. The substrate can be a PCB, a silicon wafer or the like.

Moreover, the lower support can comprise a metal primary layer above the substrate.

Furthermore, preferably, a dielectric sacrificial layer is interposed between the substrate and the primary layer. The dielectric sacrificial layer can be for example a polymeric layer.

Both the sacrificial layer and the primary layer can be deposited in a uniform manner on the whole substrate or in a localized manner.

Preferably, the step of etching the first photoresist layer, and neatly the successive layers as well, so as to form a plurality of through openings is performed according to a lithographic process.

The manufacture by successive layers through a photolithographic process allows vertical orifices, directed in the normal direction to the upper face of the interface element, to be alternated with substantially horizontal connectors therebetween, so as to define a broken profile of the conductor.

In particular, said layers can comprise thicker layers alternated with less thick layers; the openings formed at the thicker layers being vertical vias whose extension in the vertical direction prevails with respect to the extension in the horizontal direction; the vias formed at the less thick layers being horizontal vias whose extension in the horizontal direction prevails with respect to the extension in the vertical direction; the corresponding conductive segments being vertical segments and horizontal segments respectively.

Preferably, filling the plurality of through openings, formed by the overlapping of the single through openings of the photoresist layers, with a conductive material allows to form at least one conductive segment. This step is performed through a galvanic growth process in which metal structures are in fact grown. These metal structures, also indicated as conductive segments, can be of various materials, among which metals, metal alloys or the like.

As an alternative, the step of filling the plurality of through openings with a conductive material is mainly performed through the galvanic growth process, it can also be performed through cathode sputtering, thermal evaporation or other deposition techniques.

The process defined for the single photoresist layer can be repeated for a multiplicity of photoresist layers, cyclically repeating the steps (e, f, g). During the overlapping of the photoresist layers, each layer can be composed of a positive photoresist layer and/or a negative photoresist layer.

The method for manufacturing an interface element can, preferably, comprise a metal upper support positioned above the plurality of photoresist layers. This metal upper support aims at conferring a structural stability to the metal parts formed, after removing the photoresist layers. Moreover, the deposition of the metal support layer can occur through galvanic growth, sputtering, thermal evaporation or other deposition techniques.

Preferably the removal of the photoresist layers (step i) occurs through processes of the chemical type, for example through dissolution of chemical substances, through plasma treatment processes or through other techniques.

Afterwards, the plurality of conductors is embedded in an elastomeric matrix. This elastomeric matrix can be hardened, undergoing a hardening step, through exposure to UV light or through thermal treatments or through other chemical and/or physical processes.

Preferably the conductive segments formed through the method comprise vertical conductive segments and horizontal conductive segments, where the vertical conductive segments are overlapped with each other to define a straight section of the conductor extended along a first axis X which is transversal with respect to the interface element and the horizontal conductors are mainly extended along a second axis Y which is parallel to the lower support. The above results from the misalignment of the through openings, thus of the conductive segments, of a photoresist layer with the through openings of the successive and/or previous layer, which has been described above.

In order to have a good matching between the contiguous photoresist layers or between the photoresist layers and the upper support or the lower support a mechanical and/or chemical planarization step is performed preferably through lapping machines or etching techniques.

Moreover, the elastomer formed after replacing the photoresist layers with the elastomeric matrix can be detached from the lower support and/or from the upper support.

Concerning the lower support, it is possible to remove the elastomeric matrix from the substrate by removing the sacrificial layer and the metal primary layer.

The removal of the upper support is also provided with the aim of adding tips of various shapes and sizes. This addition can occur by machining through chemical and physical processes. Moreover, each tip is preferably contiguous to the conductor to which it is applied as a terminal.

The elastomer being used may then be advantageously a synthetic elastomer of the cross-linkable type, preferably through a curing process.

In particular, said layers can comprise thicker layers alternated with less thick layers; the openings formed at the thicker layers being vertical vias whose extension in the vertical direction prevails with respect to the extension in the horizontal direction; the vias formed at the less thick layers being horizontal vias whose extension in the horizontal direction prevails with respect to the extension in the vertical direction; the corresponding conductive segments being vertical segments and horizontal segments respectively.

The features and advantages of the assembly method will be apparent from the description of an exemplary embodiment given by way of nonlimiting example with reference to the attached drawings.

### Brief description of the drawings

Figure 1 schematically shows a photoresist layer.
Figures 2-16 schematically show the successive steps of a process for manufacturing an interface element;

### Detailed description

With reference to the figures of the attached drawings, an interface element arranged to put a plurality of terminations of a device to be tested in contact with corresponding channels of a testing head is globally and schematically identified with 1.

It should be first pointed out that the figures are schematic views and are not drawn to scale but so as to emphasize the most important aspects and features of the present disclosure. The shapes of the elements and of the parts composing the interface element are not to be understood in a binding sense as well.

The interface element 1 is illustrated in the figures in an embodiment configuration. The relative and absolute positions and orientations of the various parts composing the element, defined by terms like upper and lower, above and below, horizontal and vertical or other equivalent terms, are always to be construed with reference to this configuration.

As identified in the paragraph dedicated to the field of application, the interface element 1 allows to put a plurality of terminations or pads of the device in contact with corresponding channels of the testing head so as to automatically perform some desired tests on the electric device to be tested allowing defective products to be discarded.

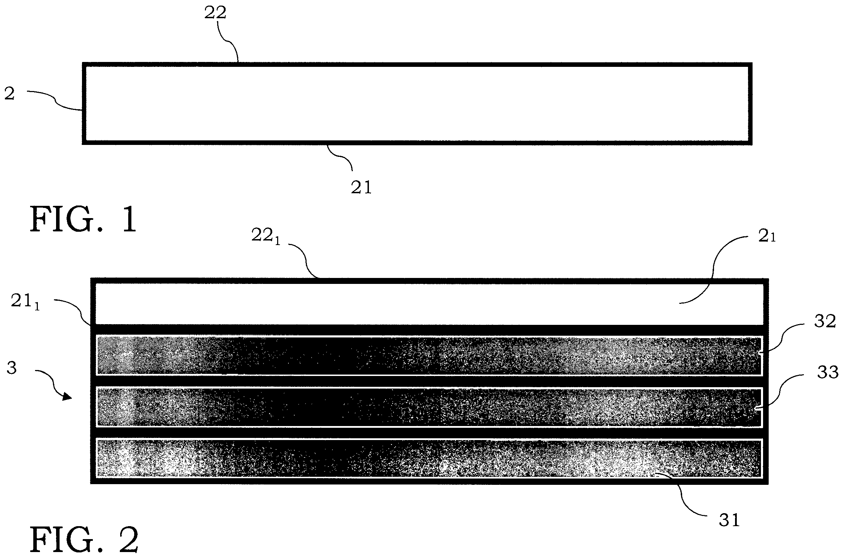

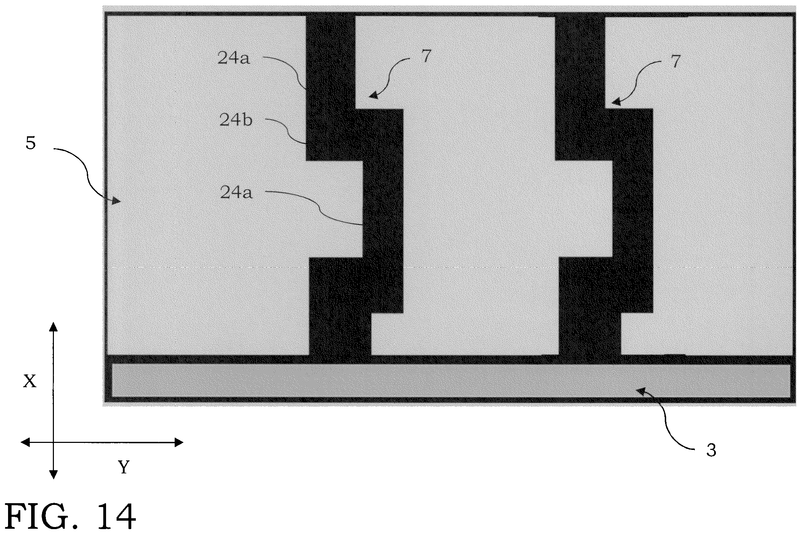

An interface device 1, which can be individually seen in Figure 14, is obtained through a manufacturing process by successive layers, illustrated in figures 2 to 14 and described hereafter.

In Figure 1 a general photoresist layer 2 is schematically illustrated. Said layer extends between a general lower face 21 and upper face 22, which are both horizontal.

In the detailed description of the process, for all that concerns the photoresist layers, after the number indicating the element subscripts from 1 to n will be associated, so as to allow in an easier manner a placement of the layer which is referred to, thus allowing a clearer explanation of the method. As mentioned, the subscripts will range from 1 to n, where the subscript 1 will be associated with the first photoresist layer while n will be associated with the last photoresist layer.

In a first process step a lower support 3, which can be seen in Figure 2, is arranged.

Afterwards, always as illustrated in Figure 2, a first photoresist layer 2₁ is deposited on said lower support 3. The first layer extends between a lower face 21₁ and an upper face 22₁, which are both horizontal.

Preferably, the lower cover 3 on which the photoresist layer 2₁ is deposited comprises at least one substrate 31. Said lower cover 3 can further comprise a metal primary layer 32 and/or a sacrificial layer 33.

In this regard, the configuration comprising a single photoresist layer 2₁ and the layers belonging to the lower cover 3 is shown in Figure 2. It should be clarified how the placement order of the layers in the lower cover 3 illustrated is to be understood in a demonstrative and nonlimiting sense.

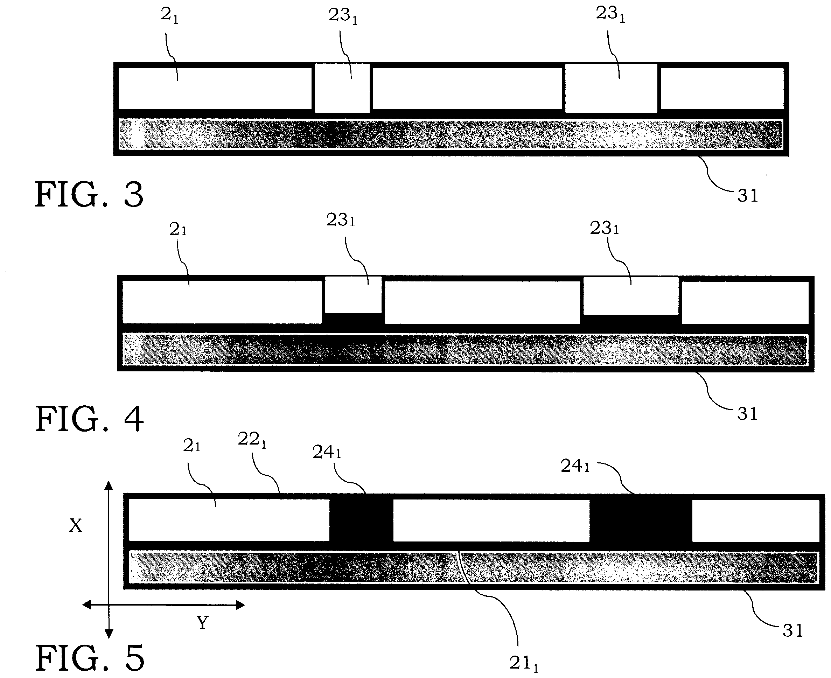

In a third process step, illustrated in Figure 3, the first photoresist layer 2₁ is etched so as to form a plurality of through openings 23₁. It should be specified that the number of through openings 23₁ represented in Figure 3 is simply illustrative and has not to be understood in a limited sense.

The etching of the photoresist layer 2₁ can occur, in a known manner per se, by using a lithographic process.

The above through openings 23₁, obtained in the photoresist 2₁, connect the upper face 22₁ to the lower face 21₁ and in a fourth method step, shown in Figure 4, said through openings 23₁ are gradually filled with a conductive metal up to reach a configuration, shown in Figure 5, in which filling the vias 23₁ results in the formation of conductive segments 24₁ which connect the lower face 21₁ to the upper face 22₁ of said photoresist layer 2₁.

Moreover, all the conductive segments 24 obtained in the general photoresist layer 2 take the thickness, in a direction X, of the photoresist layer 2 on which they are obtained and they can have a different length, in a direction Y, the one with respect to the other.

The above filling with a conductive metal can be performed through galvanic growth, cathode sputtering, thermal evaporation or other deposition techniques.

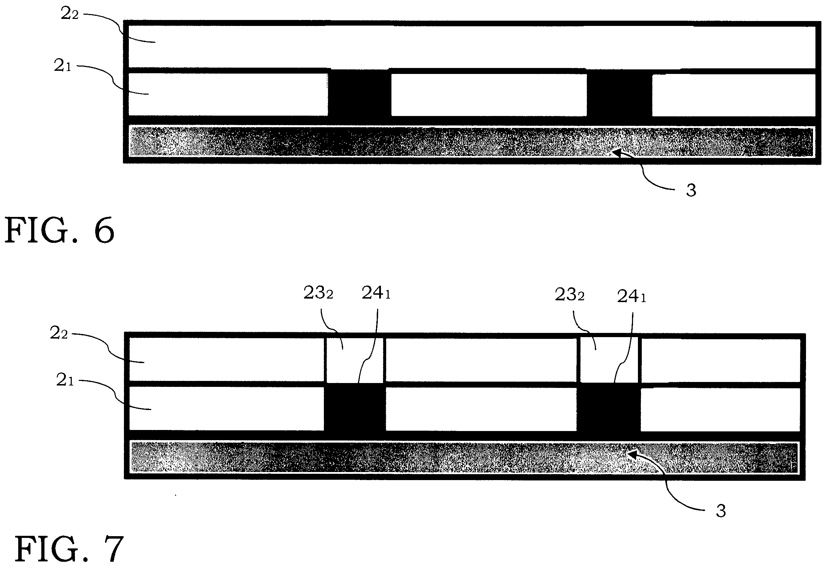

A successive photoresist layer 2₂ is deposited on the first photoresist layer 2₁, as shown in Figure 6.

In a following step, illustrated in Figure 7 said successive photoresist layer 2₂ is etched so as to form a plurality of through openings 23₂, where the through openings 23₂ of the successive photoresist layer 2₂ are in line with the through openings 23₁ of the previous photoresist layer 2₁.

This one too as well as any successive etching can occur through a lithographic process.

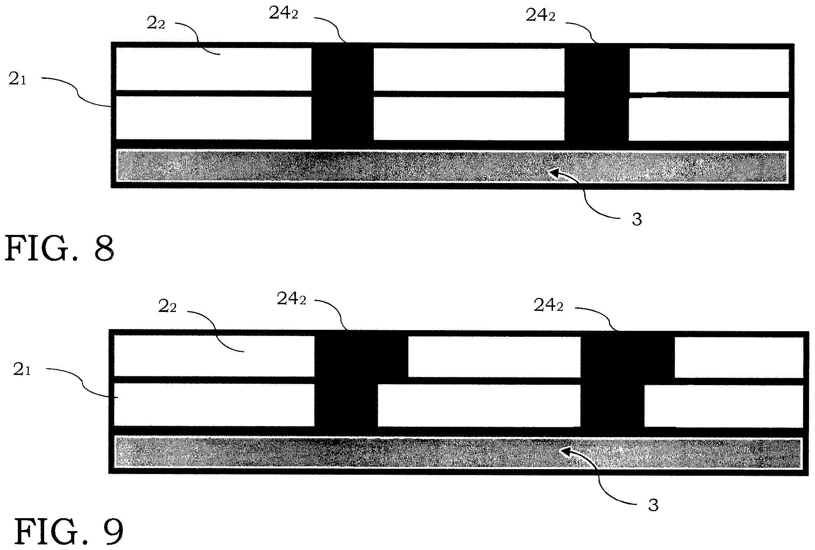

Like for the previous layer, and as it can be clearly seen in Figure 8, said plurality of through openings 23₂ of said successive photoresist layer 2₂ can be filled with a conductive material so as to form a corresponding plurality of conductive segments 24₂.

This one too as well as any successive filling can be performed through deposition techniques, for example of the above-identified type.

Once the conductive segments 24₂ is formed, the process described for the successive photoresist layer 2₂ is cyclically repeated. The thickness of the successive deposited photoresist layers 2 can vary, depending on the process requirements and on the desired interface element 1, so as to obtain conductive segments 24 which are more or less extended in the direction X.

Specifically, it is possible to repeat in a cyclic sequence and in the described order the method steps comprising depositing the photoresist layer 2, etching the photoresist layer 2 so as to obtain a plurality of through openings 23 and filling said plurality of through openings 23 so as to obtain the formation of conductive segments 24. As already mentioned, the described steps, intended for the cyclic repetition, can be seen in Figures 6, 7, 8.

The structure of the various metal layers can be aligned or not with the one of the previous layer. An example of aligned metal structure can be seen in Figure 8 while an example of misaligned metal structure can be seen in Figure 9. By simple way of example, they are both represented as a structure having two photoresist layers 2 with corresponding conductive segments 24.

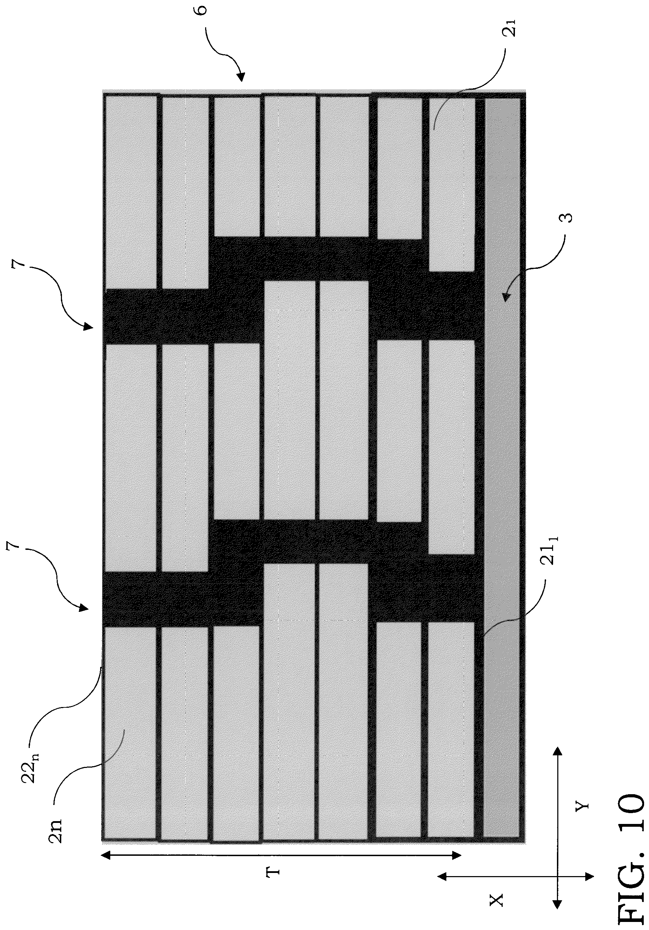

The cyclic repetition of these steps, illustrated in Figures 6, 7, and 8 leads to the manufacture of a multilayer matrix 6 of metal structures encapsulated in photoresist layers, which can be seen in Figure 10. The number of layers varies depending on the process and construction requirements of the desired interface element.

The multilayer matrix 6, represented in Figure 10, is in this case and by way of example a misaligned matrix comprising a plurality of photoresist layers 2, from layer 1 to layer n, each comprising one or more conductive segments 24.

A multilayer matrix 6 as illustrated in Figure 10 is therefore manufactured, which has a plurality of photoresist layers 2 overlapped to define an overall thickness T developed along a vertical direction X. The so-obtained multilayer matrix 6, and coupled to the lower cover 3, has a plurality of conductors 7 which pass through a matrix of photoresist layers 2 from the lower face 21i of the lower photoresist layer 2₁, to the upper face 22ₙ of the upper photoresist layer 2ₙ.

As it is apparent from the description of the manufacturing method, the conductors 7 develop according to broken lines i.e. which alternate vertical segments, extended along the vertical direction X, with horizontal segments extended along a horizontal direction Y which is substantially normal to the vertical direction X.

The alternation between vertical and horizontal segments confers to the conductor a spring conformation which ensures the elasticity required to the application in testing heads.

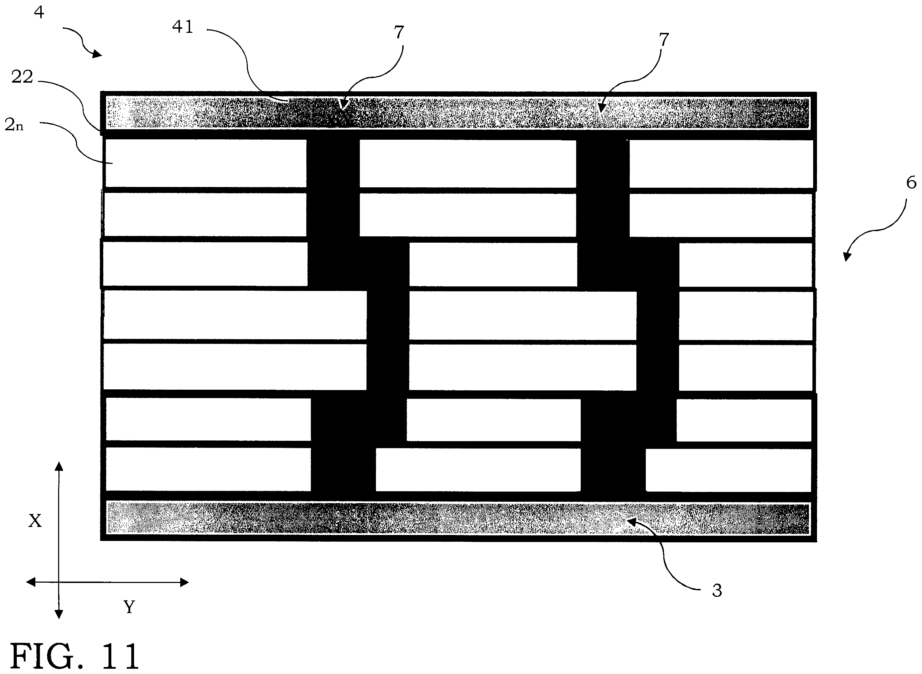

In a following step, which can be seen in Figure 11, an upper cover 4 is deposited. Said upper cover 4 preferably comprises a metal layer 41 deposited on the upper face 22ₙ of the upper photoresist layer 2ₙ.

A following process step consists in removing the photoresist layers 2, from layer 1 to layer n, in which the conductors 7 are obtained by overlapping the various conductive segments 24, from those obtained in layer 1 up to those obtained in layer n. The photoresist 2 is usually chemically removed.

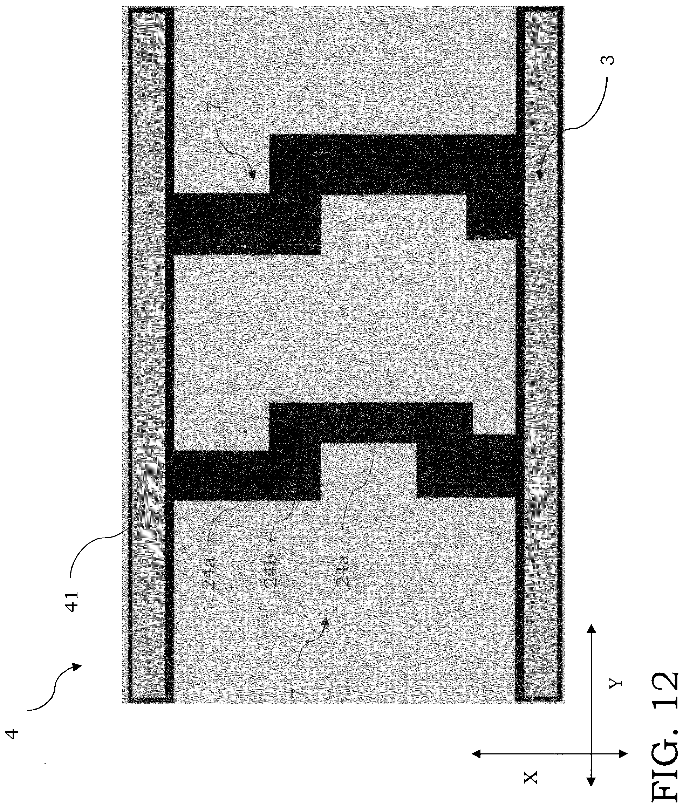

After removing the n photoresist layers 2 a metal structure is obtained, illustrated in Figure 12, comprising the lower cover 3, the upper cover 4 and the conductors 7.

After removing the n photoresist layers 2 the metal structure composed of lower cover 3, upper cover 4 and conductors 7 can be encapsulated in an elastomeric matrix 5 which can then be hardened.

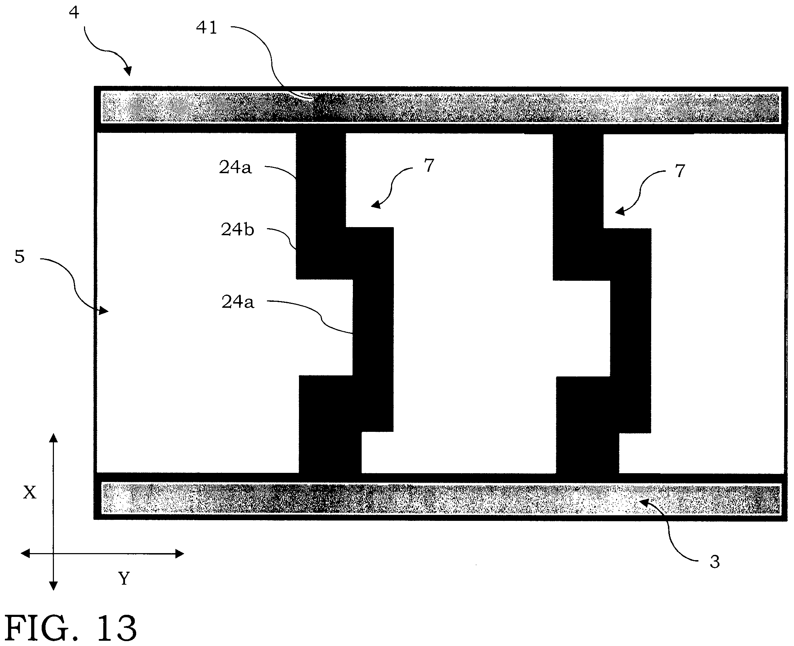

The structure just described and comprising the hardened elastomeric matrix 5 can be seen in Figure 13.

The method can also provide the removal of the upper cover 4, once the hardening of the elastomeric material 5 is finished, up to obtain the conformation illustrated in Figure 14.

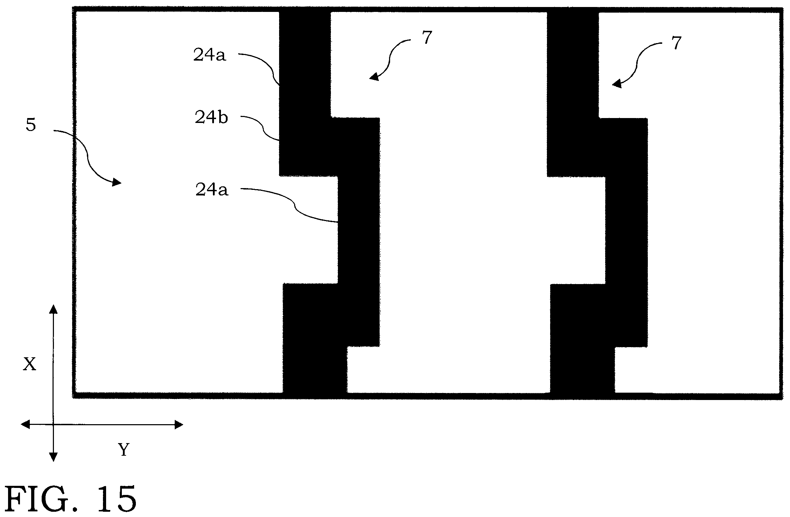

If required, the removal of the lower cover 3 can be performed so as to obtain a structure comprising the conductors 7 and the hardened elastomeric material 5, as can be seen in Figure 15.

Finally, in a terminal phase of the method for forming an interface element 1, tips 8 of various shapes and sizes can be positioned in close proximity to the area for removing the upper cover 4.

Said tips 8 allow the connection, in one of the several possible applications, of the probes, through such interface element 1, to the element to be measured or tested.

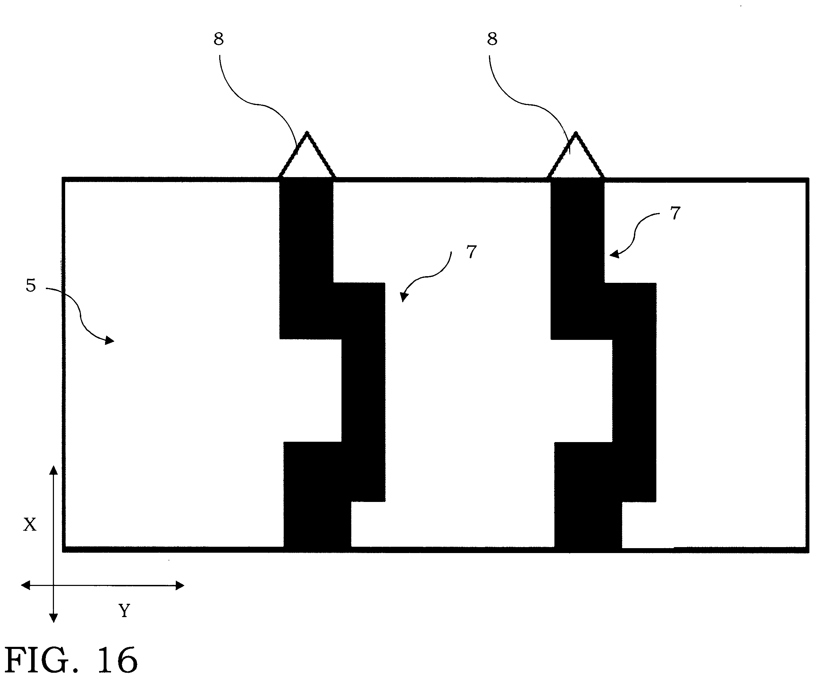

The interface element 1 comprising said tips 8 is schematically shown in Figure 16.

Hence, the solution of the present disclosure solves the technical problem and achieves several advantages including: a particularly reduced cost, a great structural and functional reliability and an optimum adaptability of the manufacturing process.

In understanding the scope of the present invention, the term "comprising" and derivatives thereof, as used herein, are intended as open terms which specify the presence of the specified features, elements, components, groups, integers and/or steps, but do not exclude the presence of other non-specified features, elements, components, groups, integers and/or steps. The foregoing also applies to words having similar meanings such as for example the terms, "including", "having" and derivatives thereof. Moreover, the terms "cover", "face", "section" and "portion" when used in the singular form may have the double meaning of a single part or of a plurality of parts unless otherwise specified.

Although only selected embodiments were chosen to illustrate the present invention, it will be apparent to the persons skilled in the art from this disclosure that various changes and modifications can be brought here without departing from the scope of the invention as defined in the attached claims.

## Claims

1. A method for manufacturing an interface element (1) arranged to put a plurality of terminations of a device to be tested in contact with the corresponding channels of a testing head, comprising the steps of:
a) arranging a planar lower support (3);
b) depositing a first photoresist layer (2i) on said lower support (3);
c) etching said first photoresist layer (2i) so as to form a plurality of through openings (23₁) in said first photoresist layer (2₁);
d) filling said plurality of through openings (23₁) with a conductive material so as to form at least one conductive segment (24₁);
e) depositing a successive photoresist layer (2₂) on the previous photoresist layer (2₁);
f) etching said successive photoresist layer (2₂) so as to form a plurality of through openings (23₂), where the through openings (23₂) of the successive photoresist layer (2₂) are in line with the through openings (23₁) of the previous photoresist layer (2₁);
g) filling said plurality of through openings (23₂) of said successive photoresist layer (2₂) with a conductive material so as to form a corresponding plurality of conductive segments (24₂);
h) repeating the steps (e, f, g) up to reach a desired thickness, where the conductive segments (24₁₋ₙ) which are contiguous to each other define a plurality of conductors (7);
i) removing the photoresist layers (2₁₋ₙ);
j) embedding said plurality of conductors (7) in an elastomeric matrix (5).

2. The method for manufacturing an interface element (1) according to claim 1, wherein said lower support (3) comprises a substrate (31) and a metal primary layer (33) above said substrate (31).

3. The method for manufacturing an interface element (1) according to claim 2, wherein said lower support (3) further comprises a dielectric sacrificial layer (33) interposed between said substrate (31) and said primary layer (33).

4. The method for manufacturing an interface element (1) according to any one of the claims, wherein the step of forming said plurality of through openings (23), repeated for each photoresist layer (2), is performed according to a lithographic process.

5. The method for manufacturing an interface element (1), according to one of the previous claims, wherein the step of filling said plurality of through openings (23) with a conductive material so as to form at least one conductive segment (24), repeated for each photoresist layer (2), is performed through galvanic growth, cathode sputtering, thermal evaporation or other deposition techniques.

6. The method for manufacturing an interface element (1), according to claim 1, wherein each different photoresist layer (2) is a positive photoresist layer and/or a negative photoresist layer.

7. The method for manufacturing an interface element (1), according to one of the previous claims, further comprising a step of depositing a metal upper support (4) above the plurality of photoresist layers (2).

8. The method for manufacturing an interface element (1), according to claim 7, wherein the deposition of said upper support (4) occurs through galvanic growth, sputtering or thermal evaporation.

9. The method for manufacturing an interface element (1), according to any one of the previous claims, wherein the step of embedding said plurality of conductors (7) in an elastomeric matrix (5) comprises a step of hardening the elastomeric material (5).

10. The method for manufacturing an interface element (1), according to any one of the previous claims, wherein at least some of the conductive segments (24) of at least one photoresist layer (2) are misaligned with respect to the conductive segments (24) which are contiguous to each other of the previous and/or successive photoresist layer (2).

11. The method for manufacturing an interface element (1), according to claim 10, wherein the conductive segments (24) comprise vertical conductive segments (24a) and horizontal conductive segments (24b), wherein the vertical conductive segments (24a) are overlapped with each other to define a straight section of the conductor (7) extended along a first axis (X) which is transversal with respect to the interface element (1) and the horizontal conductors (24b) are mainly extended along a second axis (Y) which is parallel to the lower support (3).

12. The method for manufacturing an interface element (1), according to any one of the previous claims, wherein a mechanical and/or chemical planarization step is performed between two contiguous photoresist layers.

13. The method for manufacturing an interface element (1), according to any one of the previous claims, wherein the removal of the lower support (3) and/or upper support (4) is provided.

14. The method for manufacturing an interface element (1), according to the previous claim, wherein, after removing the upper support (4), the addition of tips (8), of various shapes and sizes, is provided, each one electrically connected to the respective conductor (7).

15. An interface element (1) arranged to put a plurality of terminations of a device to be tested in contact with the corresponding channels of a testing head, said interface element (1) being manufactured through a method according to one of the previous claims.
